Europäisches Patentamt

European Patent Office

Office européen des brevets

(11) Publication number: **0 313 792**
**A1**

## EUROPEAN PATENT APPLICATION

(21) Application number: **88115212.8**

(22) Date of filing: **16.09.88**

(51) Int. Cl.⁴: **G01R 19/04**

(30) Priority: **26.10.87 IT 2240987**

(43) Date of publication of application:
**03.05.89 Bulletin 89/18**

(84) Designated Contracting States:
**DE FR GB**

(71) Applicant: **SGS-THOMSON MICROELECTRONICS s.r.l.**
**Via C. Olivetti, 2**
**I-20041 Agrate Brianza Milan(IT)**

(72) Inventor: **Wolfsgruber, Arturo**
**Via Val Pellice, 15**
**I-20153 Milan(IT)**

(74) Representative: **Perani, Aurelio et al**
**c/o JACOBACCI-CASETTA & PERANI 7, Via**
**Visconti di Modrone**
**I-20122 Milano(IT)**

(54) **A full-wave peak detector device.**

(57) A full-wave peak detector device (1), of a type which comprises a differential cell (2) having first (T1) and second (T2) transistors with their respective emitters (E1,E2) interconnected, and a filter capacitor (C) having one end connected to the base (B2) of said second transistor (T2) and the other end connected to ground, further comprises a third transistor (T3) having its collector (C3) and emitter (E3) respectively connected to the collector (C1) and the emitter (E1) of the first transistor (T1) in the differential cell (2). This device (1) can be connected directly to the output of a differential stage (3) having applied to its inputs a signal with a high rate of amplitude modulation.

EP 0 313 792 A1

This invention relates to a full wave peak detector device of a type which comprises a differential cell having first and second transistors with their respective emitters interconnected, and a filter capacitor connected at one end to the base of said second transistor and at the other end to ground.

As is known, peak detector devices belong to the class of the memory circuits which can store up a generic instantaneous signal value.

In particular, peak detectors can store up the positive or negative maximum value of a signal, and the memory element is formed therein by a capacitor.

A peak detector of a basic type consists of a rectifying diode and a capacitor so interconnected as to have, by raising the value of the input voltage, the diode biased forwardly and therefore the capacitor charged. The capacitor is charged to the maximum positive value of the input signal and retains its charge indefinitely.

Such rectifiers are generally utilized as demodulators in amplitude-modulated RF signal receiver apparatus.

Such rectifier-demodulators are required to output as faithful as possible a reproduction of the input signal. However, owing to the presence of the diodes, rectified voltage values are output which are lower than the input one and also affected by temperature.

This results in an error which is the more significant the lower is the peak value of input signal.

To obviate this drawback, a prior art proposal provides for the use of a peak detector consisting of a differential cell connected to the capacitor via a current mirror circuit. A signal to be demodulated is applied to the non-inverting input of a differential amplifier, the output of which is connected via a current mirror circuit to the detector capacitor and the inverting input of the differential amplifier, thus achieving full feedback.

This known approach, while avoiding the use of a rectifying diode, has the drawback that it requires an intermediate push-pull stage.

The technical problem underlying this invention is to provide a peak detector device which has such structural and performance characteristics as to overcome the cited drawbacks in relation to the prior art, while doing away with the need to use rectifying diodes.

This problem is solved by a device as indicated being characterized in that it comprises a further transistor having its collector and emitter respectively connected to the collector and the emitter of said first transistor.

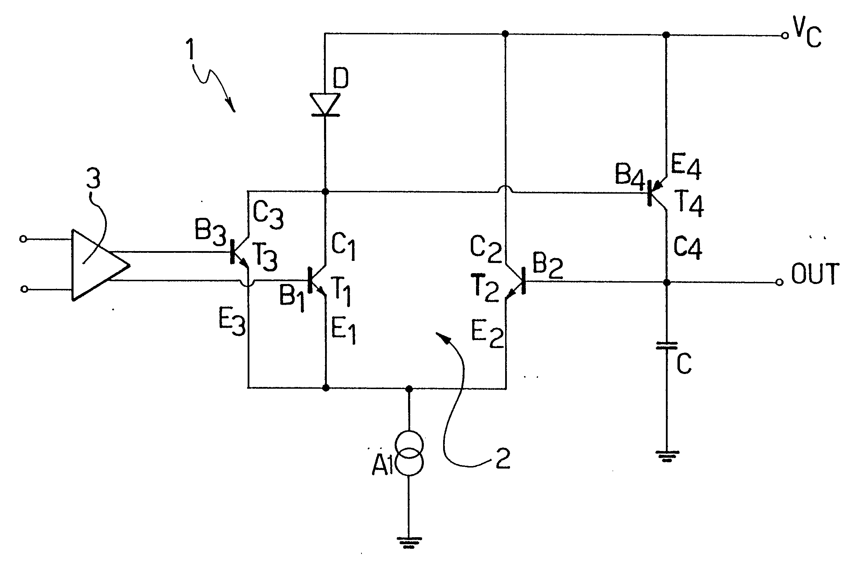

The features and advantages of the device according to the invention will become apparent from the following detailed description of an exemplary embodiment thereof, to be taken by way of illustration and not of limitation in conjunction with the accompanying drawing.

The drawing shows a schematical view of a peak detector device according to the invention.

With reference to the drawing, the numeral 1 designates generally and schematically a full-wave peak detector circuit device according to this invention.

The detector 1 comprises a differential cell 2 having a

first transistor T1 and second transistor T2, both of the npn type, which have their respective emitters E1 and E2 connected together and to ground via a current source A1.

The collector C1 of the transistor T1 is connected to a positive supply pole VC via a diode D, and is connected to the base B4 of a transistor T4 of the pnp type having its emitter E4 connected to the pole VC and its collector C4 connected to an output terminal OUT to which one end of a capacitor C, referred to as the filter capacitor for the detector 1, is also connected.

The collector C2 of the transistor T2 is connected directly to the supply pole VC; the base B2 of that transistor T2 being connected directly to the terminal OUT associated with one end of the capacitor C. The other end of the capacitor C is connected to ground.

Advantageously, according to the invention, a third transitor, T3 of the npn type, is provided which has its collector C3 connected to the collector C1 of the transistor T1, and the emitter E3 connected to the emitters E1 and E2 of the transistors T1 and T2.

The respective bases B1 and B3 of the transistors T1 and T3 constitute, therefore, respective inputs to the detector 1, and are connected to the respective outputs of a differential amplifier stage 3, the inputs whereof are applied an amplitude modulated analog signal.

The operation of the device according to the invention will be now described.

A voltage signal to be demodulated, as applied to the input of the amplifier stage 3, is supplied to the respective bases B1 and B3 of the transistors T1 and T3, which act as rectifiers for each half-wave of the input signal.

So long as the voltage on the bases B1 and B3 is alternately higher than that at the base B2 of the second transistor of the cell 2, to which the capacitor C is connected, the current mirror circuit formed of the diode D and the transistor T4 will keep that capacitor C charged.

This condition is maintained until a balance is struck between the voltage levels at B2 and at B1 and B2.

The device of this invention has a major advantage in its simple construction, in addition to its ability to connect directly to the output of a single differential stage to whose input the signal to be demodulated is applied.

Laboratory tests carried out by the Applicant have proved that such a device is little affected by second harmonics distortion from the stages ahead.

Another advantage comes from that it requires a capacitance of halved value with respect to those utilized in comparable prior devices.

## Claims

1. A full-wave peak detector device (1) of a type which comprises a differential cell (2) having first (T1) and second (T2) transistors with their respective emitters (E1,E2) interconnected, and a filter capacitor (C) connected at one end to the base (B2) of said second transistor (T2) and at the other end to ground, characterized in that it comprises a further transistor (T3) having its collector (C3) and emitter (E3) respectively connected to the collector (C1) and the emitter (E1) of said first transistor (T1).

2. A device according to Claim 1, characterized in that the respective bases (B1,B2) of said first (T1) and further (T3) transistors are connected directly to the respective outputs of a differential amplifier stage (3).

EP 0 313 792 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | ELECTRONIC ENGINEERING, vol. 49, no. 598, October 1977, page 23; J. HAWKE: "Low offset peak detector circuit uses transistors" * Whole article * | 1 | G 01 R 19/04 |
| Y | IBM TECHNICAL DISCLOSURE BULLETIN, vol. 29, no. 10, March 1987, pages 4516-4517, Armonk, NY, US; "Multiple-input over-voltage, under-voltage window comparator for computer power supplies" * Whole article * | 1 | |
| A | NEUES AUS DER TECHNIK, no. 6, 15th December 1982, page 3, Würzburg, DE; "Schmitt-Trigger-Schaltung mit mehreren Eingängen" * Whole article * | 1 | |
| A | EP-A-0 087 893 (LINEAR TECHNOLOGY) * Page 10, lines 17-25; figure 3 * | 1,2 | TECHNICAL FIELDS SEARCHED (Int. Cl.4) G 01 R H 03 K |

The present search report has been drawn up for all claims

| Place of search | Date of completion of the search | Examiner |
|---|---|---|
| THE HAGUE | 09-02-1989 | WIEMANN L. |